# EUROPEAN PATENT SPECIFICATION

(11) **EP 2 768 025 B1**
(45) Date of publication and mention of the grant of the patent: **06.01.2016**
(21) Application number: 14168605.5
(22) Date of filing: 24.09.2003
(51) Int. Cl.: H01L 27/146, H01L 21/768, H01L 23/48, H01L 27/144

(54) **Photodiode array**
Fotodiodenarray
Matrice de photodiodes

(30) Priority: 24.09.2002 JP 2002277948
(43) Date of publication of application: 20.08.2014
(62) Divisional of application: 12173415.6
(73) Proprietor: HAMAMATSU PHOTONICS K. K., Hamamatsu-shi, Shizuoka 435-8558 (JP)
(72) Inventor: Shibayama, Katsumi, Hamamatsu-shi, Shizuoka 435-8558 (JP)
(74) Representative: Boult Wade Tennant

(56) References cited:
- JP-A- 5 029 483
- JP-A- 2001 318 155
- JP-U- 3 028 759

## Description

### Technical Field

The present invention relates to a photodiode array and method for manufacturing the same.

### Background Art

An increase in area has been demanded for a CT (computed tomography) diode array In order to eliminate insensitive regions, three-dimensional mounting for disposing a signal processing part on the side (back side) opposite the light incidence surface is required. For this, electrodes formed on the incidence surface side (front surface side) are extended to the opposite side (back side) of the incidence surface by using through-hole interconnections.

Semiconductor devices using such through-hole interconnections are disclosed in, for example, Patent Document 1 and Patent Document 2, etc., described below. In the semiconductor device disclosed in Patent Document 1, a substrate is etched by using wet etching using an alkali solution to form through-holes, so that the substrate is etched at an angle of 54.7 degrees with respect to the substrate front surface.

Patent Document 1: Japanese Published Unexamined Patent Application No. H05-29483

Patent Document 2: Japanese Published Unexamined Patent Application No. H06-177201

### Disclosure of the Invention

However, when electrodes of photodiodes of a photodiode array are connected by through-hole interconnections by using this technique, the through-holes gradually expand their diameters from the front side to the back side. Therefore, the photodiodes cannot be formed particularly proximate to each other, and the aperture ratio is limited.

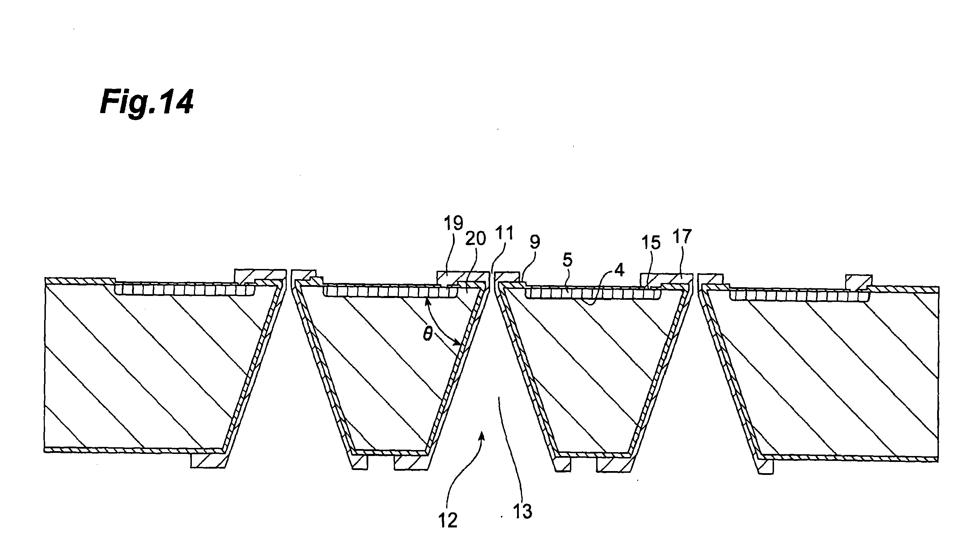

FIG 14 is a sectional view of a photodiode array of a prior art.

As shown in FIG 14, when only the above-described etching is used, the angle θ between the substrate front side surface and the surface of the through-hole inner wall becomes acute. Therefore, when the corner 20 regulating this acute angle is covered by the through-hole interconnection 17, a conducting error easily occurs due to defective coverage on the portion of the corner 20.

On the other hand, it is also considered that through-holes perpendicular to the substrate front surface are formed by dry-etching, however, in actuality, it is impossible that through-holes with even hole diameters are formed in a substrate with a thickness of 250 through 400µm. In addition, since dry-etching is low in speed, it takes a long time to perforate the substrate with a thickness of 250 through 400µm.

Therefore, an object of the invention is to solve the above-mentioned problem and provide a photodiode array in which conducting errors hardly occur in the through-hole interconnections and has a high aperture ratio.

In order to solve the above-mentioned problem, the photodiode array of the invention is defined in claim 1.

Also described herein is a semiconductor substrate including a plurality of pn junction type photodiodes formed in an array on the light incidence side of a first conduction-type substrate and a surface opposite the incidence surface is formed of a (100) plane, and has through-holes that are formed in regions sandwiched between the photodiodes and penetrate the semiconductor substrate from the incidence surface side to the opposite surface side, wherein conductor layers continued from the incidence surface to the opposite surface through the wall faces of the through-holes are provided, and the through-hole has a perpendicular hole portion formed almost perpendicular to the incidence surface on the incidence surface side and a pyramidal hole portion having a quadrangular pyramidal shape formed on the opposite side, the perpendicular hole portion and the pyramidal hole portion are connected inside the semiconductor substrate, and the wall face of the pyramidal hole portion is formed of a (111) plane.

"Almost perpendicular" means an intersection at an angle in a range of 85 through 90 degrees.

According to the above-mentioned photodiode array, the angles of corners covered by the conductor layers continued from the incidence surface to the opposite surface through the wall faces of the through-holes are all 90 degrees or more, so that conducting failures due to defective coverage by the conductor layers hardly occur. Furthermore, the photodiodes can be made proximate to each other, the aperture ratio can be increased.

The photodiode array may have first conduction type high-impurity concentration layers formed so as to surround the through-holes inside the semiconductor substrate.

Since the above-described photodiode array has high-impurity concentration layers around the through-holes, even when unnecessary carriers occur due to mechanical damage on the through holes, they can be trapped within the layers, and leak currents and dark currents can be restrained.

Also described herein is a method for manufacturing a photodiode array comprising the following steps:
- a first step in which a semiconductor substrate having a first surface of a (100) plane is prepared and a plurality of pn junction type photodiodes are formed into an array in predetermined regions of a second surface opposite the first surface;
- a second step in which a pyramidal concave portion having a quadrangular pyramidal shape with a depth less than the thickness of the semiconductor substrate from the first surface side of the semiconductor substrate is formed by means of anisotropic etching for each photodiode;
- a third step in which perpendicular holes almost perpendicular to the second surface are formed by dry-etching from the second surface side at positions corresponding to the pyramidal concave portions, and the pyramidal concave portions and the perpendicular holes are connected to each other to form through-holes penetrating the semiconductor substrate from the second surface to the first surface.
- a fourth step in which conductor layers continued from the second surface to the first surface through the through-holes are formed.

According to this manufacturing method, perpendicular holes are formed after the pyramidal concave portions having quadrangular pyramidal shapes are formed. The depth of the pyramidal concave portions to be formed is less than the thickness of the semiconductor substrate, so that the etching solution does not leak to the second surface side, so that there is no harmful influence on the photodiodes on the second surface side.

### Aspects of the invention

Aspects of the invention are set forth in the following numbered clauses:
Clause 1. A photodiode array comprising a semiconductor substrate including a plurality of pn junction type photodiodes formed in an array on a light incidence side of a first conduction-type substrate,
   wherein a surface opposite the incidence surface is formed of a (100) plane;
   wherein the semiconductor substrate has through-holes that are formed in regions sandwiched between the photodiodes and penetrate the semiconductor substrate from the incidence surface side to the opposite surface side;
   wherein conductor layers continued from the incidence surface to the opposite surface through the wall faces of the through-holes are provided;
   wherein the through-hole includes:
   a perpendicular hole portion formed almost perpendicular to the incidence surface on the incidence surface side, and
   a pyramidal hole portion having a quadrangular pyramidal shape formed on the opposite surface side;
   wherein the perpendicular hole portions and the pyramidal hole portions are connected inside the semiconductor substrate; and
   wherein the wall face of the pyramidal hole portion is a (111) plane. Clause 2. The photodiode array according to Clause 1, wherein inside the semiconductor substrate, first conduction type high-impurity concentration layers formed so as to surround the through-holes are provided.
Clause 3. A method for manufacturing a photodiode array comprising:
   a first step in which a semiconductor substrate including a first surface of a (100) plane is prepared and a plurality of pn junction type photodiodes are formed in an array form in predetermined regions on a second surface opposite the first surface,
   a second step in which, for each of the plurality of photodiodes, a pyramidal concave portion having a quadrangular pyramidal shape with a depth less than the thickness of the semiconductor substrate is formed from the first surface side of the semiconductor substrate by anisotropic etching,
   a third step in which perpendicular holes almost perpendicular to the first surface are formed by dry-etching from the second surface side at positions corresponding to the pyramidal concave portions, and the pyramidal concave portions and the perpendicular holes are connected to form through-holes that penetrate the semiconductor substrate from the second surface to the first surface, and
   a fourth step in which conductor layers continued from the second surface to the first surface through the through-holes are formed.
Clause 4. A photodiode array (1) comprising a semiconductor substrate (3) including a plurality of pn junction type photodiodes (4) formed in an array on a light incidence side of a first conduction-type substrate,
   Wherein a surface opposite the incidence surface is formed of a (100) plane;
   wherein the semiconductor substrate (3) has through-holes (12) that are formed in regions sandwiched between the photodiodes (4) and penetrate the semiconductor substrate from the incidence surface side to an opposite surface side;
   wherein conductor layers (17) continued from the incidence surface to the opposite surface through the wall faces of the through-holes (12) are provided;
   wherein the through-hole (12) includes:
   a perpendicular hole portion (11) formed almost perpendicular to the incidence surface on the incidence surface side, and
   a pyramidal hole portion (13) having a quadrangular pyramidal shape formed on the opposite surface side;
   wherein the perpendicular hole portions (11) and the cone hole portions (13) are connected inside the semiconductor substrate (3); and
   wherein the wall face of the pyramidal hole portion (13) is a (111) plane.
Clause 5. A method for manufacturing a photodiode array (1) comprising:
   a first step in which a semiconductor substrate (3) including a first surface is prepared and a plurality of pn junction type photodiodes (4) are formed in an array form in predetermined regions on a second surface opposite the first surface,
   a second step in which, for each of the plurality of photodiodes (4), a cone hole portion (13) having a quadrangular pyramidal shape with a depth less than the thickness of the semiconductor substrate (3) is formed from the first surface side of the semiconductor substrate by etching,
   a third step in which perpendicular holes (11) almost perpendicular to the first surface are formed by dry-etching from the second surface side at positions corresponding to the cone hole portions (13), and the cone hole portions (13) and the perpendicular holes (12) are connected to form through-holes that penetrate the semiconductor substrate (3) from the second surface to the first surface, and
   a fourth step in which conductor layers (17) continued from the second surface to the first surface through the through-holes (12) are formed. Clause 6. The photodiode array according to Clause 6 wherein
   the first surface is a (100) plane,
   the shape of the cone hole portions (13) has a quadrangular pyramidal shape; and
   the etching is an anisotropic etching.
Clause 7. The photodiode array according to Clause 5 or 6, wherein inside the semiconductor substrate (3), first conduction type high-impurity concentration layers (17), formed so as to surround the through-holes (12), and provided.

### Brief Description of the Drawings

FIG 1 is a plan view of a photodiode array relating to a first embodiment;
FIG 2 is a sectional view of the photodiode array relating to the first embodiment;
FIG 3A is a plan view of a portion where a through-hole is formed;
FIG 3B is a III-III arrow longitudinal sectional view of the portion where a through-hole is formed;
FIG 3C is a perspective view of the portion where a through-hole is formed;
FIG 4 is a sectional view of a photodiode array;
FIG 5 is a sectional view of a photodiode array;
FIG 6 is a sectional view of a photodiode array;
FIG 7 is a sectional view of a photodiode array for describing photodiode array manufacturing processes;
FIG 8 is a sectional view of the photodiode array for describing photodiode array manufacturing processes;
FIG 9 is a sectional view of the photodiode array for describing photodiode array manufacturing processes;
FIG 10 is a sectional view of the photodiode array for describing photodiode array manufacturing processes;
FIG 11 is a sectional view of the photodiode array for describing photodiode array manufacturing processes;
FIG 12 is a sectional view of a photodiode array;
FIG 13A is a sectional view of the portion of the throuch-hole of the photodiode array;
FIG 13B is a sectional view of the portion of the through-hole of the photodiode array;
FIG 14 is a sectional view of a photodiode array of a prior art.

### Best Modes for Carrying Out the Invention

Hereinafter, embodiments of the invention are described. The same symbols are used for the same elements, and overlapping description is omitted.

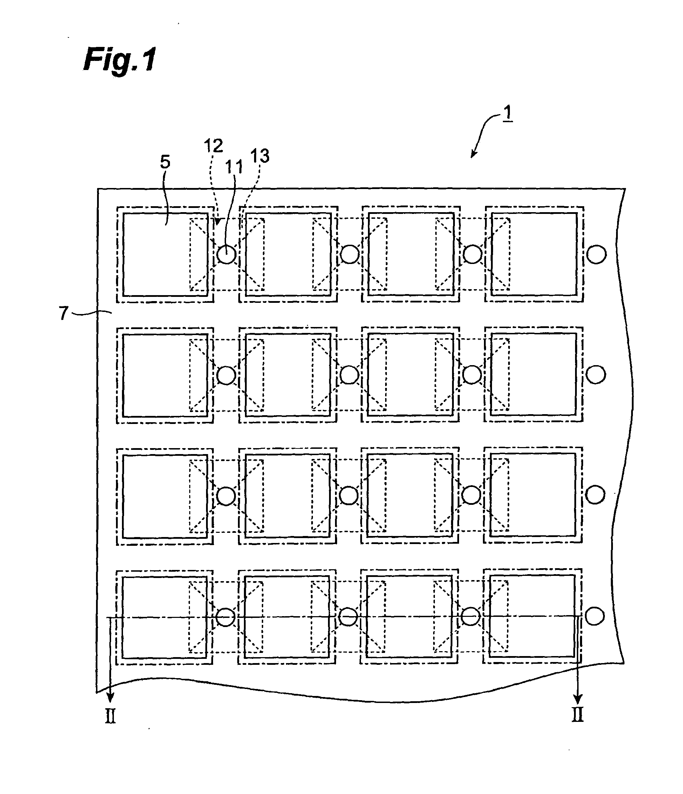

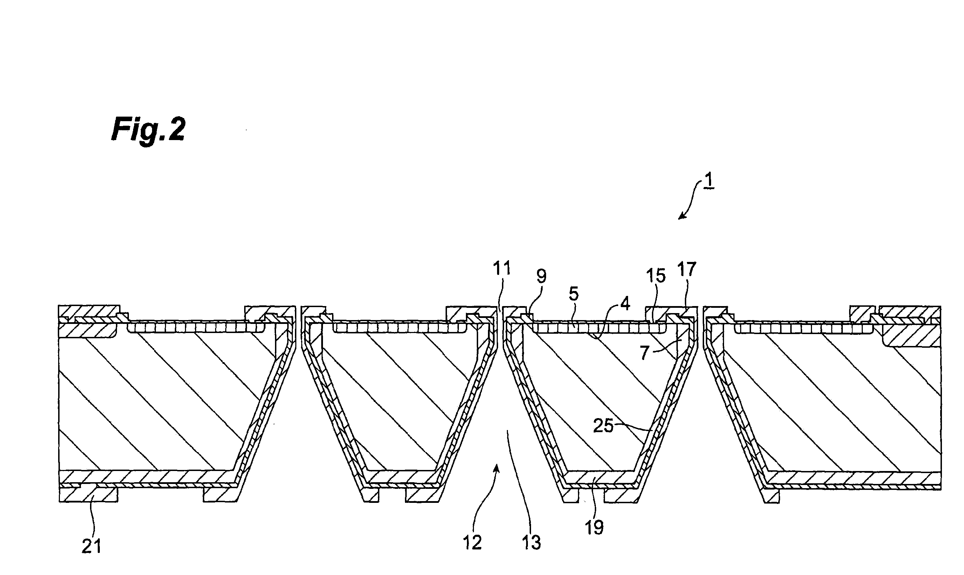

FIG 1 is a plan view of a part of a photodiode array of a first embodiment of the invention in an enlarged manner, and FIG 2 is a sectional view of the same.

In the description given below, the surface on which light made incident is defined as a front surface, and a surface opposite thereto is defined as a back surface. The photodiode array 1 of this embodiment includes a plurality of pn junctions (photodiodes) 4 arranged in an orderly array form longitudinally and laterally on the front surface side, and each of the pn junctions has a function as a photosensitive pixel.

The photodiode array 1 has an n-type silicon substrate 3 with a thickness of 270µm and an impurity concentration of 1×10¹² to 10¹⁵/cm³, and a plurality of p-type impurity diffused layers 5 with a size of 500µm×500µm and an impurity concentration of 1×10¹³ to 10²⁰/cm³ are arranged at pitches of approximately 1.5mm.

The photosensitive pixels are formed by pn junctions 4 formed of the n-type silicon substrate 3 and the plurality of p-type impurity diffused layers 5. Between the p-type impurity diffused layers 5, n⁺-type impurity regions (separation layers) 7 that separate the photodiodes and reduce dark currents by trapping unnecessary carriers are arranged. On the back side, n⁺ side electrodes 21 are formed.

Between adjacent pn junctions 4, a first hole portion 11 (perpendicular hole portion) is formed on the front side and a second hole portion 13 (pyramidal hole portion) is formed on the back side.

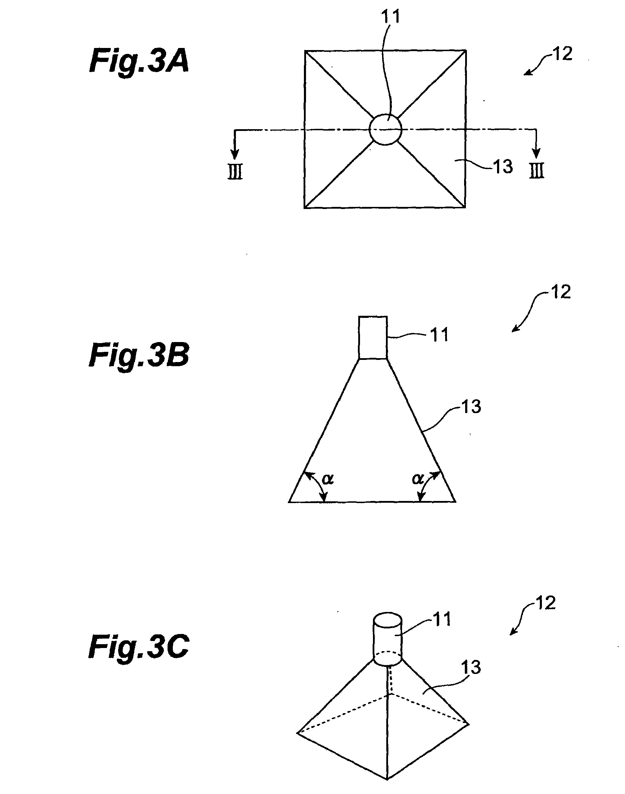

FIG 3A is a plan view of a portion where a through-hole is formed, FIG 3B is a III-III arrow longitudinal sectional view of the portion where a through-hole is formed, and FIG 3C is a perspective view of the portion where a through-hole is formed.

The through-hole 12 is formed by connecting the first hole portion 11 and the second hole portion 13. The first hole portion 11 is opened at a diameter of 10µm on the front side of the substrate, in parallel to the thickness direction of the substrate. The first hole portion 11 is formed into a columnar shape in parallel to the thickness direction of the substrate at a position penetrating the separation layer 7. The depth of the hole is formed to be equal to or deeper than the depth of the p-type impurity diffused layer. Thereby, the second hole portion 13 does not limit the depletion layer extending from the pn junction 4, whereby the p-type impurity diffused layers 5 can be provided proximate to each other.

The second hole portion 13 is formed into a quadrangular pyramidal shape from the substrate back side, and its hole diameter increases toward the back side and becomes smaller toward the front side. Since the second hole portion 13 is formed from the back side by anisotropic etching, the (111) plane is exposed to the hole portion wall face, and the wall face has an angle of approximately 54.7 degrees with respect to the front surface of the photodiode array (α:the angle of FIG 3B ≈ 54.7 degrees). By forming the second hole portion 13 into a quadrangular pyramid, it becomes easy to provide a conductor layer (through-hole interconnection) on the hole portion inner wall.

The first hole portion 11 and the second hole portion 13 are connected inside the substrate to form one through-hole 12. The substrate front surface and back surface including the wall faces of the through-holes 12 and the front sides of the p-type impurity diffused layers 5 are covered by thermal oxide films 9. Instead of the silicon oxide films, AR (antireflection) coating may be formed according to the required wavelength sensitivity of the photodiodes. The AR coating may be a single layer of SiO₂ or SiNₓ, or an insulator compound film or laminated film containing these.

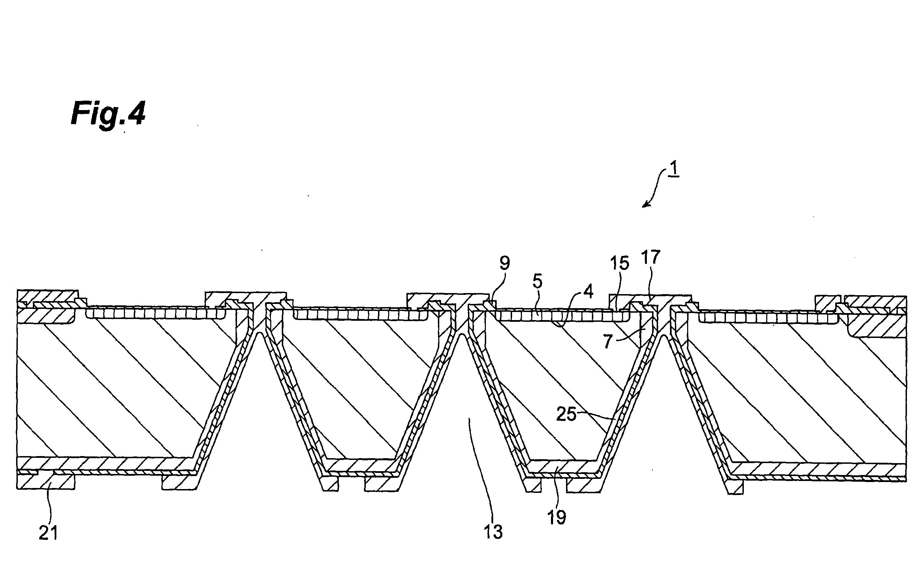

The through-hole interconnection 17 is formed from aluminum on the upper layer of the thermal oxide film 9, and is in contact with the p-type impurity diffused layer 5 through the contact hole 15 opened through the thermal oxide film 9. Furthermore, it is formed continuously to the back side through the wall face of the through-hole 12, and can make electrical contact with the p-type impurity diffused layer 5 from the back side. In this case, even when the first hole portion 11 is filled with the metal of the through-hole interconnection 17 and spatially isolates the substrate front side and the substrate back side from each other, there is no problem since the electrical contact between the p-type impurity diffused layer 5 and the back side is not lost (see FIG 4).

FIG 4 is a sectional view of a photodiode array In this photodiode array, the inside of the first hole portion 11 is filled with the through-hole interconnection 17, however, the back surface of the photodiode array is electrically connected to the p-type impurity diffused layer 5.

Herein, the material of the through-hole interconnection 17 is not limited to aluminum, and copper, nickel, gold, tungsten, titanium, or polysilicon, etc., or an alloy or laminated metal containing these may be used. Furthermore, instead of the thermal oxide film 9, an oxide film obtained by CVD may be used. An oxide film or nitride film obtained by CVD may interpose between the thermal oxide film 9 and the through-hole interconnection 17. Thereby, high insulation performance can be obtained between the silicon substrate and the through-hole interconnection 17.

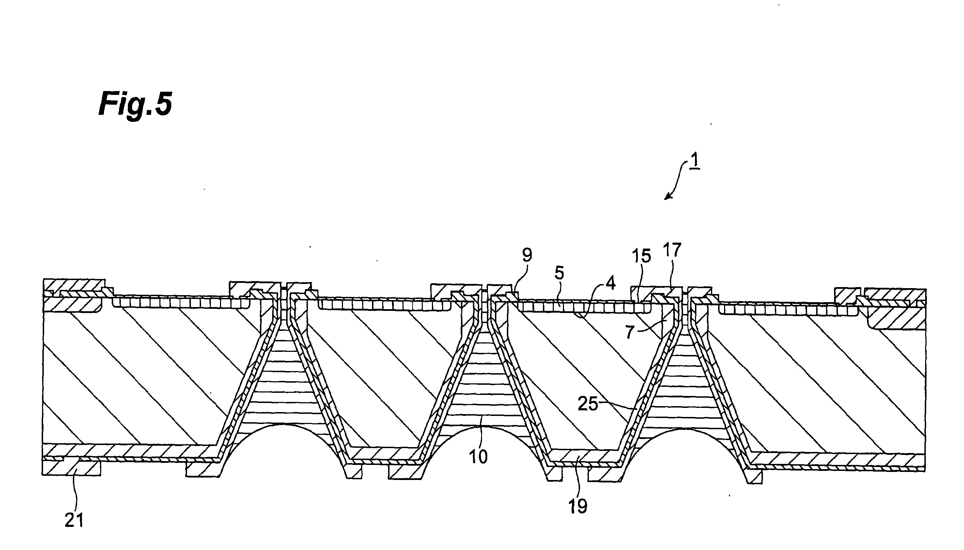

FIG 5 is a sectional view of a photodiode array. In this photodiode array, by filling a filling material 10 such as a resin or the like in the upper layer of the through-hole interconnection 17 inside the through-hole 12, the through-hole is filled up. Thereby, the substrate front side and the back side are spatially isolated from each other, however, the electrical contact between the p-type impurity diffused layers 5 and the back side is not lost, and the mechanical strength of the photodiode array 1 can be improved.

At this point, as a material to be filled in the through-hole 12, a resin-based insulating material containing epoxy, polyimide, acryl, silicone, and urethane, etc., or an electrical conductive resin containing an electrical conductive filler in these insulating materials is used.

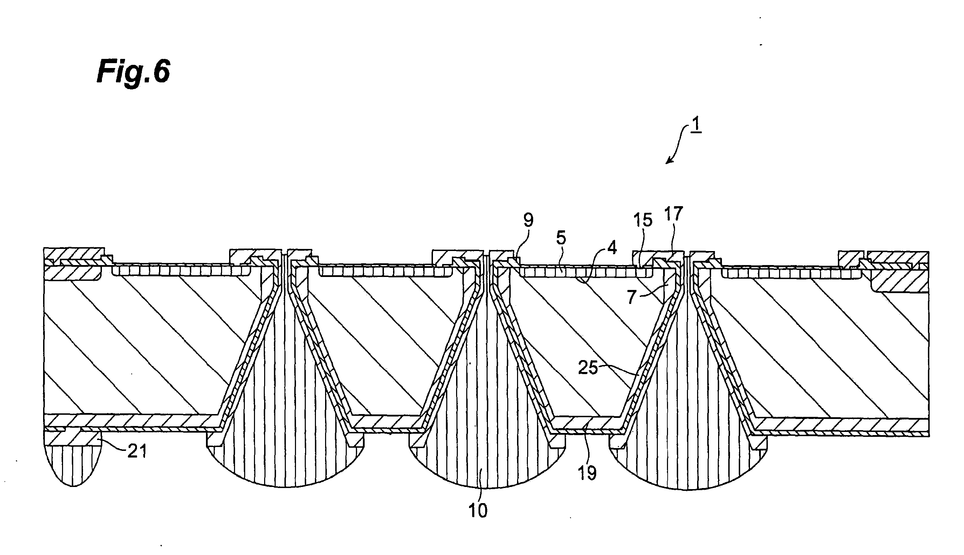

FIG 6 is a sectional view of a photodiode array.

The through-hole 12 may be filled up by filling the conductive material 10 inside the through-hole 12. The filled conductive material not only improves the mechanical strength of the photodiode array 1 but also is used as a bump electrode by protruding it over the edge of the back surface of the second hole portion 13 and forming the portion protruding over the back surface edge into a semisphere. As the conductive material 10, an electrical conductive resin or the like containing solder or an electrical conductive filler is used.

Next, a method for manufacturing the photodiode array is described.

Hereinafter, a method for manufacturing a photodiode array in which a polyimide resin is filled inside the through-holes 12 (see FIG 5) is described.

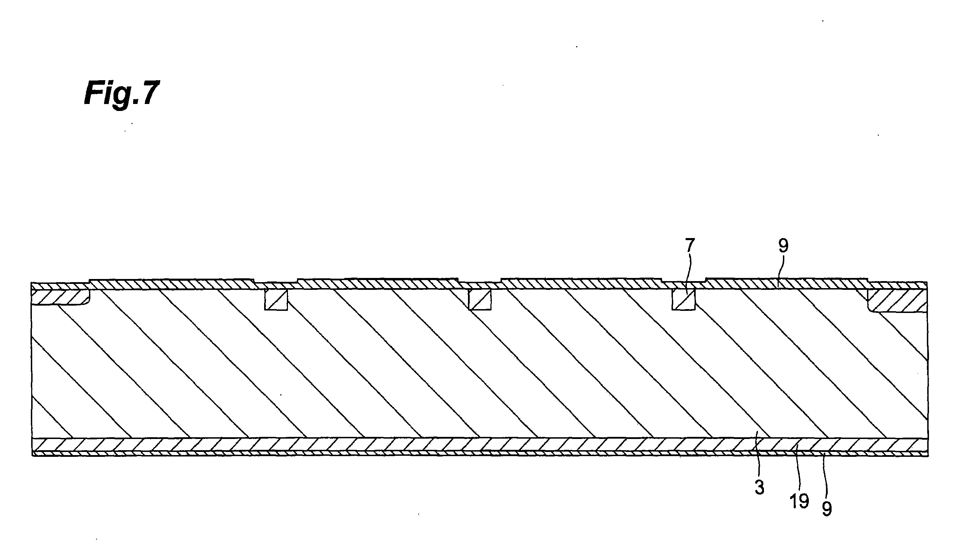

FIG 7 is a sectional view of the photodiode array for describing photodiode array manufacturing processes.

First, an n-type semiconductor substrate 3 of a crystal (100) plane is prepared. A thermal oxide film 9 is formed on the substrate front surface and used as a mask for n⁺ thermal diffusion of the next step. The thermal oxide film is opened by a photo-etching process at the positions for separation layers 7 and phosphorus is thermally diffused and thermal oxidization is applied. At this point, phosphorus is also diffused all over the back surface, and an n⁺-type impurity concentration layer 19 is formed.

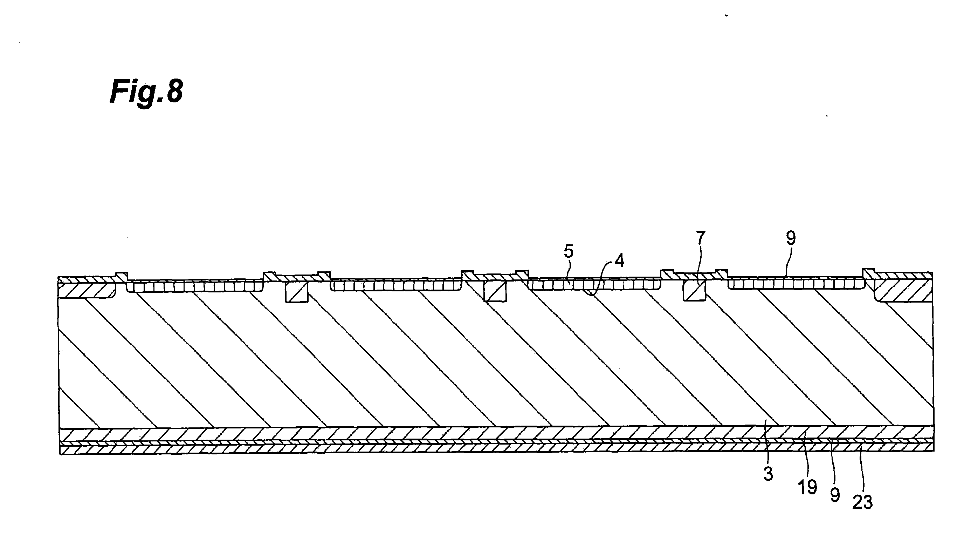

FIG 8 is a sectional view of the photodiode array for describing photodiode array manufacturing processes.

Next, the thermal oxide film in the regions for forming pn junctions 4 are opened in the same manner and boron is thermally diffused, and thermal oxidization is applied. The regions of the pn junctions correspond to the photosensitive pixels. A silicon nitride film (SiNₓ) 23 is formed by plasma CVD or LP-CVD on the back surface (see FIG 8), and the silicon nitride film 23 and the thermal oxide film 9 at the portions for forming the second hole portions 13 are removed by etching. The portions for forming the second hole portions 13 are at positions on the back side corresponding to the separation layers 7.

At this point, the shape and size of the portions removed of the silicon nitride film 23 are designed in advance so that the apexes of the quadrangular pyramids of the second hole portions 13 do not reach the substrate front side by alkali etching described later and the apexes of the quadrangular pyramids are at positions corresponding to the separation layers 7 on the front side.

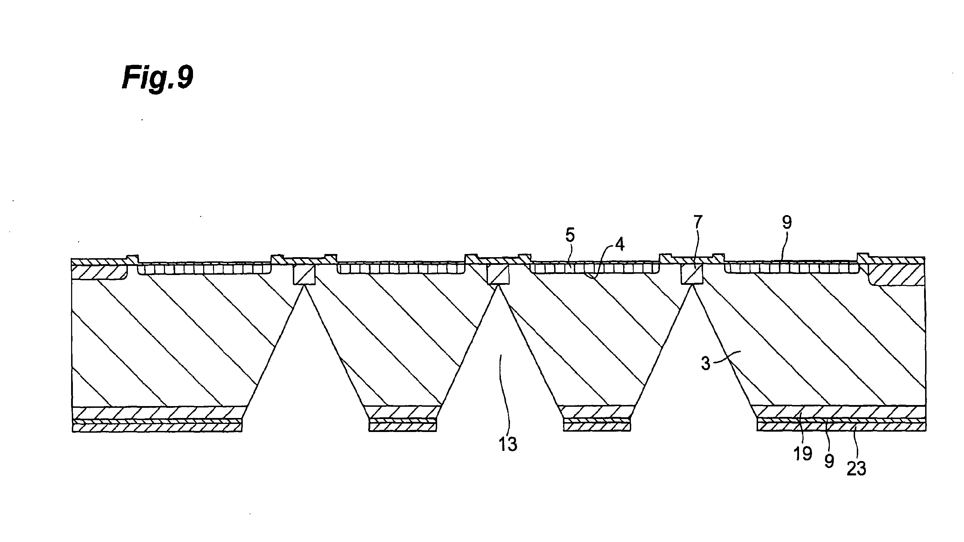

FIG 9 is a sectional view of the photodiode array for describing photodiode array manufacturing processes.

Then, anisotropic etching is applied to the semiconductor substrate 3 from the back side by means of alkali (for example, potassium hydroxide, TMAH, hydrazine, EDP, etc) etching to form the second hole portions 13. Namely, etching is applied from the crystal (100) plane of the substrate to expose the (111) plane. The second hole portions 13 are formed into quadrangular pyramidal shapes by etching, and etching is automatically stopped when etching reaches the apexes of the quadrangular pyramid shapes (see FIG 9).

Additionally, etching may be stopped before reaching the apexes of the quadrangular pyramids. Next, the portions corresponding to the apexes of formed quadrangular pyramids are dry-etched from the front side and etching is applied until the first hole portions 11 are formed and connected to the quadrangular pyramidal apexes of the second hole portions 13, and through-holes 12 are formed by the first hole portions 11 and the second hole portions 12.

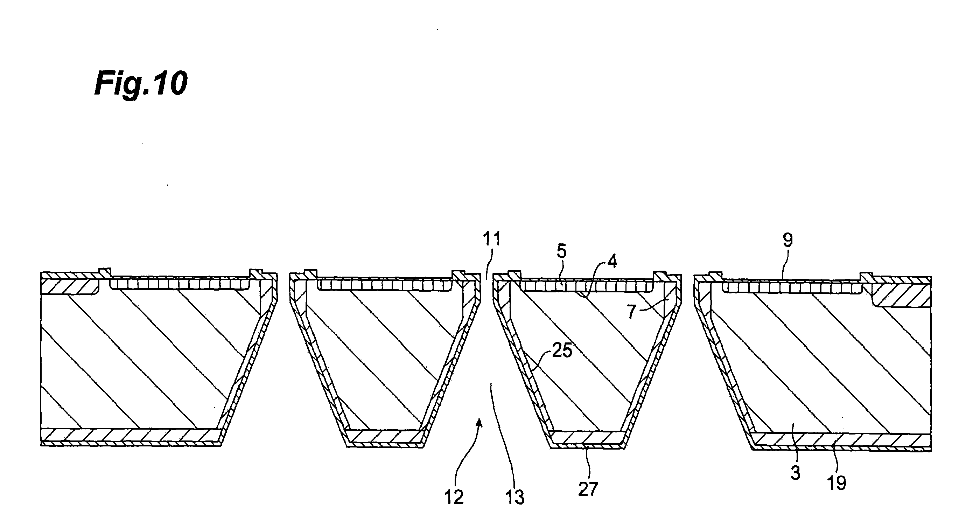

FIG 10 is a sectional view of the photodiode array for describing photodiode array manufacturing processes.

Ion implantation or diffusion is carried out from the substrate's back surface and n⁺ layers 25 surrounding the through-holes 12 are formed. The n⁺ layers 25 are connected to the separation layers 7 and the n⁺ type impurity concentration layers 19 on the back side. Thereafter, to secure insulation of the side walls, SiO₂ films 27 are formed by thermal oxidization (see FIG 10). Instead of these SiO₂ films 27, the insulating films on the side walls may be laminated films of SiNₓ or SiO₂ films formed by CVD.

Next, after forming contact holes 15 in the p⁺ layers and n⁺ layers, aluminum is deposited from both sides by a sputtering device to form through-hole interconnections 17 and a resist is formed and etching is applied to form a desired pattern. The material of the through-hole interconnections 17 is not limited to aluminum, and the method of forming the interconnections is not limited to sputtering. For example, diffusion for reducing the electrical resistance may be applied to polysilicon formed by CVD. In this case, only the contact hole portions are made of aluminum and electrically connected to the polysilicon.

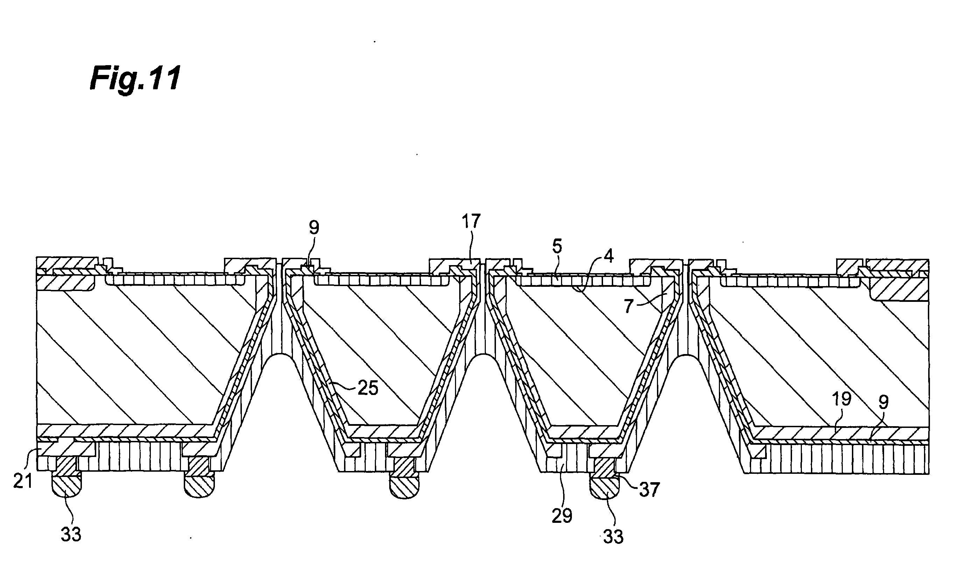

FIG 11 is a sectional view of the photodiode array for describing photodiode array manufacturing processes.

A photosensitive polyimide layer 29 is formed on the back side, and only portions where bump electrodes 33 are to be arranged are opened. At the same time, portions of the n⁺ side electrodes 21 are also opened and bump electrodes 33 are provided therein. Then, bump electrodes 33 are formed via Under Bump Metal (hereinafter, referred to as UBM) 37 formed from metal that is excellent in electrical and physical connection to the bump electrodes 33. For example, when the bump electrodes 33 are solder bumps, wettable metals must be formed and interposed so as to prevent the solders from getting wet by aluminum. The UBM in this case can be realized by forming Ni-Au by electroless plating or forming Ti-Pt-Au or Cr-Au by the liftoff technology.

In place of the polyimide layer, an acrylic layer, an epoxy layer, or a layer of a compound material of these may also be used. The solder bumps can be formed by forming solders on predetermined UBM portions by the solder ball mounting method or printing method and by reflow soldering. The bump electrodes 33 are not limited to solder bumps, and may be conductive bumps containing metals such as gold bumps, nickel bumps, copper bumps, or conductive resin bumps.

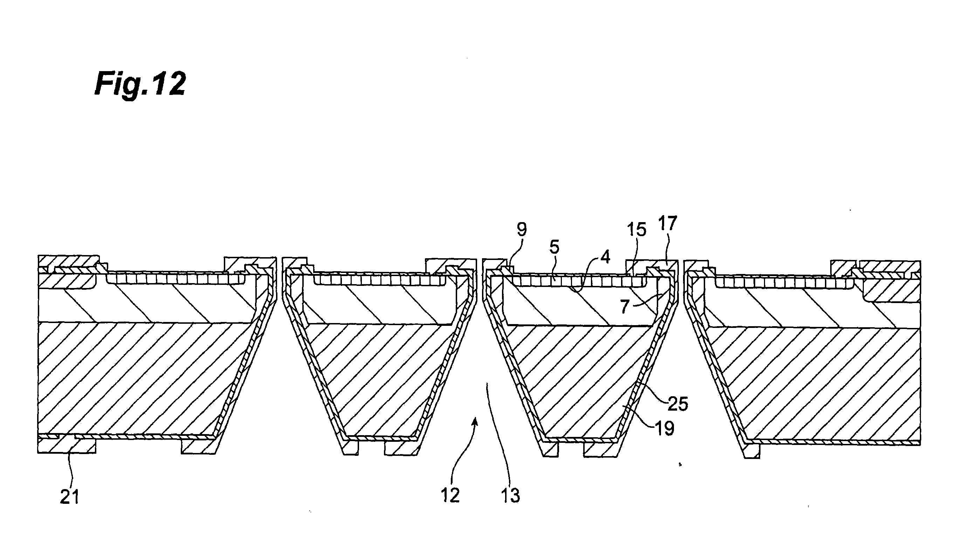

FIG 12 is a sectional view of the photodiode array.

In the above-described manufacturing method, first, an n-type semiconductor substrate is prepared and n⁺-type impurity concentration layers are formed by thermal diffusion, however, as shown in FIG 12, it is also possible that an n-type semiconductor substrate provided with an n⁺-type impurity concentration layer by means of thermal diffusion or epitaxial growth in advance is prepared. Thereby, the n⁺-type impurity concentration layers of the photodiode array can be made thick, and the intervals of the actual p-type impurity diffused layers 5 and the n⁺-type impurity concentration layers 19 can be narrowed, whereby the resistance components can be reduced and the highspeed response can be improved.

Furthermore, by adjusting the intervals of the actual p-type impurity diffused layers 5 and the n⁺-type impurity concentration layers 19, a spectral sensitivity curve according to the specifications can be obtained.

Hereinafter, actions of the photodiode array and the method for manufacturing the same are described.

In the photodiode array, the second hole portions 13 are formed first from the back side by means of alkali etching, and then the first hole portions 11 are formed, whereby the through-holes 12 are formed. Therefore, at the point of the alkali etching step, the through-holes are not completed yet, so that corrosion to the front side by the alkali etching does not occur, and particularly, there is no harmful influence on the photosensitive surface, so that yield lowering can be prevented.

Furthermore, in the alkali etching step, etching of the second hole portions 13 stops when it reaches the apexes of the quadrangular pyramidal shapes, so that separate provision of etching stop layers becomes unnecessary. Furthermore, most of the through-holes 12 (second hole portions 13) are formed by anisotropic etching, so that their wall faces have little unevennesses, and smooth through-hole wall faces can be obtained. Therefore, occurrence of unnecessary carriers due to damages on the through-hole wall faces is reduced, resulting in reduction in dark currents.

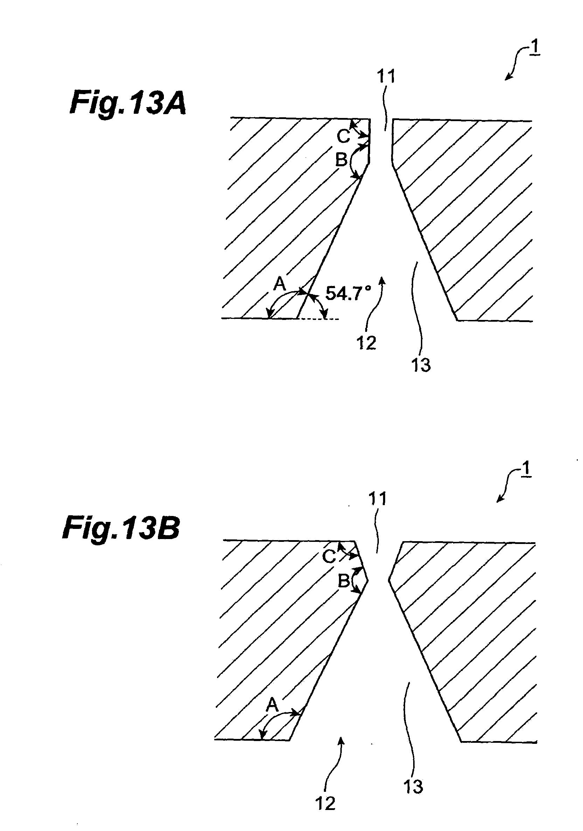

FIG 13A and FIG 13B are sectional views of the portion of the through-hole of the photodiode array.

The wall face of the second hole portion 13 has an angle of 54.7 degrees with respect to the front surface of the photodiode array, and the wall face of the first hole portion 11 is almost perpendicular to the array direction.

When the through-hole is formed of only the second hole portion 13 by using only alkali etching, the second hole portion and the photodiode array are directly connected, and the angle θ formed between these surfaces is acute.

On the other hand, in the photodiode array shown in FIG 13A, since the through-hole 12 is formed by connecting two hole portions, the angle B formed at the connecting portion of the hole portions is 90 degrees or more. Furthermore, the angle A between the second hole portion 13 and the photodiode array back surface is also 90 degrees or more, and the angle C between the first hole portion 11 and the photodiode array front surface is almost 90 degrees.

Therefore, the through-hole interconnections 17 continued from the front surface to the wall faces of the through-holes 12 and the back surface have no acute angle bends, and conducting failures due to defective coverage caused at the time of forming can be prevented. Furthermore, depending on the dry-etching conditions for forming the first hole portions 11, as shown in FIG 13B, it is also possible that the first hole portions 11 are tapered and the angle C is formed to be 90 degrees or more. Thereby, conducting failures can be further prevented.

In the photodiode array, the second hole portions 13 are formed by alkali etching, so that ion implantation to the wall faces of the through-holes 12 becomes possible, and the n⁺ layers 25 can be easily formed by ion implantation. The formed n⁺ layers 25 serve as separation layers separating photodiodes from each other, and performs the function for reducing dark currents by trapping unnecessary carriers.

In the photodiode array, the first hole portions 11 are formed so as to penetrate the separation layers 7. Therefore, during dry-etching for forming the first hole portions 11, even if the hole portion inner walls are damaged, generated unnecessary carriers are trapped in the separation layers 7. Therefore, the photodiode array can prevent leak currents caused by damage in the case of forming through-hole interconnections.

As described above, according to the invention, a photodiode array which includes through-hole interconnections that hardly cause conducting failures and has a high aperture ratio can be provided.

### Industrial Applicability

The invention is applicable to a photodiode array and a method for manufacturing the same.

## Claims

1. A photodiode array (1) for a computed tomography comprising a semiconductor substrate (3) having:
a plurality of pn junction type photodiodes (4) formed in an array on a light incidence side of the semiconductor substrate (3),
a plurality of through-holes (12), each including:
a perpendicular hole portion (11) formed at an angle in the range of 85 through 90 degrees to the incidence surface on the incidence surface side, and
a tapered hole portion (13) formed on a surface opposite the incidence surface, wherein the tapered hole portion (13) tapers inwards from the opposite surface towards the incidence surface and is connected to the perpendicular hole portion (11);
a first conduction type high impurity concentration layer (7) for surrounding the through-hole(12); and
a conductor layer (17) formed in the through hole (12) from the incidence surface to the opposite surface.

2. A photodiode array (1) according to Claim 1, further comprising a filling material (10) of resin that fills the through-holes (12).

3. A photodiode array (1) according to Claim 1, further comprising a conductive material (10) that fills the through-holes (12).

4. A photodiode array (1) according to any one of Claims 1 to 3, the depth of the first conduction type high impurity concentration layer (7) is greater than that of the pn junction (4).

5. A photodiode array (1) according to any one of Claims 1 to 4, wherein the first conduction type high impurity concentration layer (7) is a separation layer that separates the photodiodes.

## Patentansprüche

1. Photodiodenarray (1) für Computertomographie, welches ein Halbleitersubstrat (3) umfasst, welches aufweist:
eine Mehrzahl von pn-Übergangstyp-Photodioden (4), die in einem Array auf einer Lichteinfallsseite des Halbleitersubstrats (3) ausgebildet sind,
eine Mehrzahl von Durchgangslöchern (12), deren jedes enthält:
einen senkrechten Lochabschnitt (11), der mit einem Winkel im Bereich von 85 bis 90 Grad zur Einfallsoberfläche der Einfallsoberflächenseite ausgebildet ist, und
einen verjüngten Lochabschnitt (13), der an einer der Einfallsoberfläche entgegengesetzten Oberfläche ausgebildet ist, wobei der verjüngte Lochabschnitt (13) von der entgegengesetzten Oberfläche zur Einfallsoberfläche hin einwärts verjüngt ist und mit dem senkrechten Lochabschnitt (11) verbunden ist;
eine Schicht eines ersten Leitfähigkeitstyps mit hoher Verunreinigungskonzentration (7) zum Umgeben des Durchgangslochs (12); und
eine Leiterschicht (17), die in dem Durchgangsloch (12) von der Einfallsoberfläche zur entgegengesetzten Oberfläche hin ausgebildet ist.

2. Photodiodenarray (1) nach Anspruch 1, das ferner ein Füllmaterial (10) aus Harz aufweist, das die Durchgangslöcher (12) füllt.

3. Photodiodenarray (1) nach Anspruch 1, das ferner ein leitfähiges Material (10) aufweist, das die Durchgangslöcher (12) füllt.

4. Photodiodenarray (1) nach einem der Ansprüche 1 bis 3, wobei die Tiefe der Schicht des ersten Leitfähigkeitstyps mit hoher Verunreinigungskonzentration (7) größer als jene des pn-Übergangs (4) ist.

5. Photodiodenarray (1) nach einem der Ansprüche 1 bis 4, wobei die Schicht des ersten Leitfähigkeitstyps mit hoher Verunreinigungskonzentration (7) eine Trennschicht ist, welche die Photodioden trennt.

## Revendications

1. Réseau de photodiodes (1) pour une tomographie assistée par ordinateur, comprenant un substrat semi-conducteur (3) ayant :
une pluralité de photodiodes de type à jonction pn (4) formées en un réseau sur un côté d'incidence de lumière du substrat semi-conducteur (3),
une pluralité de trous traversants (12) comprenant :
une partie de trou perpendiculaire (11) formée sur un angle de 85 à 90 degrés par rapport à la surface d'incidence sur le côté de surface d'incidence, et
une partie de trou conique (13) formée sur une surface opposée à la surface d'incidence, dans lequel la partie de trou conique (13) s'effile vers l'intérieur à partir de la surface opposée vers la surface d'incidence, et est reliée à la partie de trou perpendiculaire (11) ;
une première couche à haute concentration d'impureté du type à conductivité (7) pour entourer le trou traversant (12) ; et
une couche conductrice (17) formée dans le trou traversant (12) à partir de la surface d'incidence vers la surface opposée.

2. Réseau de photodiodes (1) selon la revendication 1, comprenant en outre un matériau de remplissage (10) de résine qui remplit les trous traversants (12).

3. Réseau de photodiodes (1) selon la revendication 1, comprenant en outre un matériau conducteur (10) qui remplit les trous traversants (12).

4. Réseau de photodiodes (1) selon l'une quelconque des revendications 1 à 3, dans lequel la profondeur de la première couche à haute concentration d'impureté du type à conductivité conduction (7) est supérieure à celle de la jonction pn (4).

5. Réseau de photodiodes (1) selon l'une quelconque des revendications 1 à 4, dans lequel la première couche à haute concentration d'impureté du type à conductivité (7) est une couche de séparation qui sépare les photodiodes.
